# EUROPEAN PATENT APPLICATION

(11) **EP 2 825 004 A1**
(43) Date of publication of application: **14.01.2015**
(21) Application number: 13758350.6
(22) Date of filing: 31.01.2013
(51) Int. Cl.: H05K 1/14, H05K 1/02, H05K 3/46

(54) **THREE-DIMENSIONAL LAMINATED WIRING SUBSTRATE**

(30) Priority: 06.03.2012 JP 2012049413
(71) Applicant: Tyco Electronics Japan G.K., Takatsu-ku Kawasaki-shi Kanagawa 213-8535 (JP)
(72) Inventor: KIMURA, Takeshi, Kawasaki-shi Kanagawa 213-8535 (JP)
(74) Representative: Johnstone, Douglas Ian
(86) International application number: PCT/JP2013/052182
(87) International publication number: WO 2013/132930

(57) **Abstract**

Provided is a three-dimensional laminated wiring substrate which can be housed in a restricted space and enables highly reliable high-density wiring. A three-dimensional laminated wiring substrate (1) comprises a plurality of laminated three-dimensional wiring substrates (11, 12, 13). Each of the three-dimensional wiring substrates (11, 12, 13) has an insulating film (111) and a conductor pattern (112). The insulating film (111) is formed to constitute a three-dimensional solid plane. The conductor pattern (112) extends on the three-dimensional solid plane of the insulating film (111).

## Description

### Technical Field

The present invention relates to a three-dimensional laminated wiring substrate.

### Background Art

It is well known that a flexible substrate, for example, is folded along a folding line and disposed in order to dispose a circuit or wiring in a limited space in a case. In addition, PTL 1 discloses a three-dimensional circuit substrate obtained by forming a copper foil into a three-dimensional shape in advance, and molding the copper foil and a prepreg sheet with a molding die in a hot-press manner.

### Citation List

### Patent Literature

PTL 1: JP 09-266368 A

### Summary of Invention

### Technical Problem

Since the flexible substrate is a two-dimensional flat sheet, the flexible substrate can form a folded flat sheet, but a circuit or wiring cannot be formed so as to cover faces spreading in three dimensions corresponding to length, width, and height at a corner of a three-dimensional object for example. The same applies to the three-dimensional circuit substrate of PTL 1 where a copper foil disposed on a two-dimensional plane is folded along a folding line on this plane. For example, even if a projection, for example, can be formed on the copper foil according to the technique of PTL 1, there is a possibility that, when the copper foil is hot-pressed together with the prepreg sheet having a shape corresponding to this copper foil, a crease or a distortion might be generated in the copper foil or the copper foil might be cut in the middle.

The present invention has been made in order to solve the above problem and an object thereof is to provide a three-dimensional laminated wiring substrate that can be housed in a restricted space, and that enables highly reliable high-density wiring.

### Solution to Problems

A three-dimensional laminated wiring substrate of the present invention that achieves the above object is a three-dimensional laminated wiring substrate having a plurality of three-dimensional wiring substrates, wherein
at least one of the plurality of three-dimensional wiring substrates includes:
an insulating film formed to constitute a three-dimensional surface, and
a conductor pattern extending on the three-dimensional surface, and wherein
the plurality of three-dimensional wiring substrates are stacked one on top of another.

In the three-dimensional laminated wiring substrate of the present invention, since three-dimensional wiring substrates having a three-dimensional surface are stacked one on top of another, highly reliable high-density wiring that can be housed in such a restricted space as a corner of an electronic device, for example, can be achieved.

In this regard, in the three-dimensional laminated wiring substrate of the present invention, all the plurality of three-dimensional wiring substrates may have substantially-identical three-dimensional surfaces, and may be so stacked as to align these substantially-identical three-dimensional surfaces with each other.

The conductor patterns extending on the three-dimensional surfaces of the respective three-dimensional wiring substrates are disposed in a nesting manner. Therefore, the three-dimensional surfaces can be utilized to make denser wiring possible.

Further, in the three-dimensional laminated wiring substrate of the present invention, the plurality of three-dimensional wiring substrates may be provided with conductor patterns different in shape from each other, respectively.

According to the conductor patterns different in shape, an element having different characteristics like an antenna having a plurality of antenna elements on the plurality of three-dimensional wiring substrates, for example, can be constituted. Therefore, a plurality of functions can be housed in a space restricted regarding its shape.

Further, in the three-dimensional laminated wiring substrate of the present invention, the three-dimensional wiring substrate may be formed with a spacer projection which abuts on another three-dimensional wiring substrate adjacent to the three-dimensional wring substrate to keep a clearance from the another three-dimensional wiring substrate.

Since the spacer projection can space the adjacent three-dimensional wiring substrates from each other, the conductor patterns can be disposed on both front and back faces of the insulating film without short-circuiting the conductor patterns with each other.

Further, the three-dimensional laminated wiring substrate of the present invention may have more than two three-dimensional wiring substrates, wherein
an intermediate three-dimensional wiring substrate of the more than two three-dimensional wiring substrates that is disposed in an intermediate position is provided with a hole or a notch, and
the spacer projection extends through the hole or notch and abuts on another three-dimensional wiring substrate disposed on the opposite side with respect to the intermediate three-dimensional wiring substrate.

Further, in the three-dimensional laminated wiring substrate of the present invention, the conductor pattern of the three-dimensional wiring substrate may extend on a surface of the spacer projection, and may be in contact with the conductor pattern of the another three-dimensional wiring substrate.

The conductor patterns provided on the two adjacent three-dimensional wiring substrates can be electrically connected to each other via the spacer projection. Therefore, the conductor patterns provided on the two three-dimensional wiring substrate can form one circuit.

Further, in the three-dimensional laminated wiring substrate of the present invention, the conductor patterns of two three-dimensional wiring substrates adjacent to each other of the plurality of three-dimensional wiring substrates form parallel plate electrodes forming a capacitor element.

The capacitor element whose electrostatic capacity can be set according to the height of the spacer projection is realized.

Further, in the three-dimensional laminated wiring substrate of the present invention, projecting pieces may be provided on edges of the plurality of three-dimensional wiring substrates in positions where the projecting pieces do not overlap with each other, and the conductor patterns of the plurality of three-dimensional wiring substrates may extend on the projecting pieces of the plurality of three-dimensional wiring substrates.

The conductor patterns provided on the projecting pieces can be utilized as external connection terminals of the three-dimensional wiring substrates. At this time, contact between the external connection terminals are avoided. In addition, the external connection terminals have high visibility, which results in ease of connecting work.

Further, in the three-dimensional laminated wiring substrate of the present invention, the conductor pattern may be a plating formed by the action of a plating catalyst on the insulating film printed with the plating catalyst so as to constitute a three-dimensional surface.

On the three-dimensional laminated wiring substrate where the plating is formed on the insulating film printed and formed with a plating catalyst, the conductor pattern is continuously formed without a break over a ridge line or an apex which is a boundary between faces constituting the three-dimensional surface. Therefore, formation of a complicated conductor pattern extending on the three-dimensional surface is highly reliable.

### Advantageous Effects of Invention

As described above, according to the present invention, a three-dimensional laminated wiring substrate that can be housed in a restricted space and that enables highly reliable high-density wiring is realized.

### Brief Description of Drawings

Figure 1 is a perspective view showing a first embodiment of a three-dimensional laminated wiring substrate of the present invention;
Figure 2 is an exploded perspective view of the three-dimensional laminated wiring substrate shown in Fig. 1;
Figure 3 is a view for explaining manufacturing steps of the three-dimensional wiring substrate;
Figure 4 is a sectional view showing the structure of a three-dimensional laminated wiring substrate of a second embodiment;
Figure 5 is a sectional view showing the structure of a three-dimensional laminated wiring substrate of a third embodiment;
Figure 6 is a sectional view showing a spacer projection portion of a three-dimensional laminated wiring substrate of a fourth embodiment;
Figure 7 is a perspective view showing a three-dimensional laminated wiring substrate of a fifth embodiment; and
Figure 8 is a perspective view showing an example of application of the three-dimensional laminated wiring substrate of Fig. 7.

### Description of Embodiments

Embodiments of the present invention will be described below with reference to the drawings.

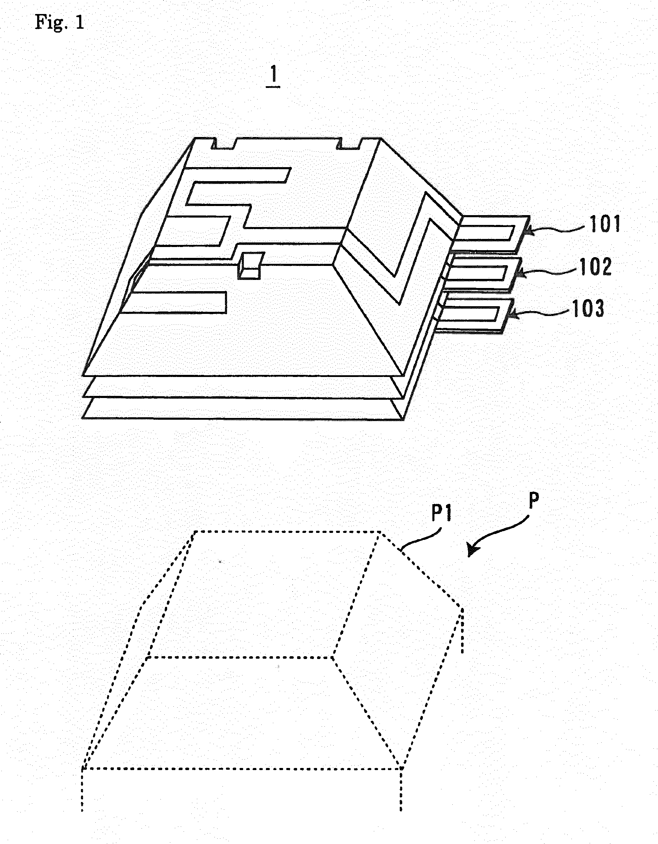

Figure 1 is a perspective view showing a first embodiment of a three-dimensional laminated wiring substrate of the present invention.

A three-dimensional laminated wiring substrate 1 shown in Figure 1 is a substrate having a shape adapted to a space in which the three-dimensional laminated wiring substrate 1 is disposed. Specifically, the three-dimensional laminated wiring substrate 1 has a three-dimensional shape for being disposed in a space between members. The three-dimensional laminated wiring substrate 1 is, for example, disposed at a corner in a case of an electronic device (not shown), and disposed in a space between the case and another component P disposed in the case. The three-dimensional laminated wiring substrate 1 of the first embodiment has a truncated-pyramid-like outer shape so as to cover a truncated pyramid portion P1 of another component P shown in broken line in Figure 1.

The illustrated three-dimensional laminated wiring substrate 1 is a wiring substrate having three circuits. More specifically, the three-dimensional wiring substrate 1 is provided with three types of antenna elements having different characteristics. Three external connection terminals 101, 102, 103 are provided on an edge of the three-dimensional laminated wiring substrate 1. Lead wires or other circuit substrates (not shown) are connected to the external connection terminals 101, 102, 103.

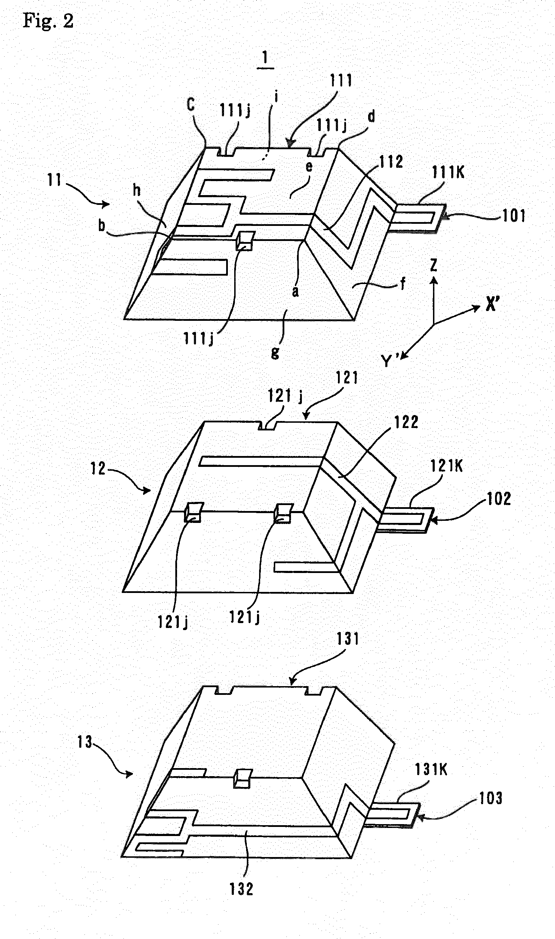

Figure 2 is an exploded perspective view of the three-dimensional laminated wiring substrate shown in Figure 1.

As shown Figure 2, the three-dimensional laminated wiring substrate 1 has three three-dimensional wiring substrates 11, 12, 13 stacked one on top of another. It should be noted that the three-dimensional wiring substrates 11, 12, 13 are also referred to as first substrate 11, second substrate 12, and third substrate 13, respectively, from top to bottom in Figure 2. First, the first substrate 11 will be described regarding a common configuration to the three-dimensional wiring substrates 11, 12, 13.

The first substrate 11 is provided with an insulating film 111 and a conductor pattern 112.

The insulating film 111 is a film made from a resin material. The resin material is a thermoplastic or thermosetting resin. The resin materials include PET (polyethylene terephthalate), PC (polycarbonate), polyimide, and PPS (polyphenylene sulfide), for example. The insulating film 111 is formed so as to constitute a three-dimensional surface. In this regard, the three-dimensional surface does not mean a shape obtained by simply folding a flat-sheet-like film along folding lines but means a shape having a portion projecting beyond a surrounding portion thereof. The insulating film 111 of the first embodiment, as a three-dimensional surface, has a truncated-pyramid-like outer shape with the bottom opened. More specifically, a top face e of the truncated-pyramid-like insulating film 111 has four apexes a, b, c, d, which are corners. Focusing on one apex a of the four apexes a, b, c, d, this apex a is in contact with faces f, g, e facing in three-dimensional directions independent of each other, which are a lateral direction (obliquely lateral direction X'), a longitudinal direction (obliquely longitudinal direction Y'), and a height direction Z. The apex a has a shape projecting relative to an annular region passing through the faces f, g, e and surrounding this apex a. The same applies to the remaining three apexes b, c, d. In addition, focusing on the top face e of the insulating film 111 of the first embodiment, it can be said that this top face e projects beyond four slanting faces f, g, h, i being in contact with four sides of the top face e and surrounding the top face e. Such a three-dimensional surface of the insulating film 111 cannot be formed by simply folding a flat-sheet-like film along folding lines and is therefore formed, for example, by hot-pressing a flat-sheet-like film with a forming die. The method of forming the insulating film 111 will be described later.

The insulating film 111 of the first substrate 11 is provided with three spacer projections 111j. The spacer projections 111j project toward the second substrate 12 adjacent to the first substrate 11. The spacer projections 111j abut on the second substrate 12 when the first substrate 11 is stacked on the second substrate 12. This keeps a clearance between most parts of the first substrate 11 except the spacer projections 111j and the second substrate 12.

In addition, the insulating film 111 is provided with a projecting piece 111k projecting from an edge thereof. The conductor pattern 112 of the first substrate 11 extends up to a top of the projecting piece 111k. The conductor pattern 112 on the projecting piece 111k constitutes the external connection terminal 101.

The structure of the first substrate 11 described above is also common to the second substrate 12 and the third substrate 13. The first substrate 11, the second substrate 12, and the third substrate 13 each have a similar (substantially the same) three-dimensional surface. Further, the first substrate 11, the second substrate 12, and the third substrate 13, in the state shown in Figure 1, are stacked so that their three-dimensional surfaces are aligned with each other.

The spacer projections 111j of the first substrate 11 and the spacer projections 121j of the second substrate 12 are disposed at different positions. This prevents the spacer projection 111j of the first substrate 11 from falling into the spacer projection 121j of the second substrate 12 when the first substrate 11 is stacked on the second substrate 12. More specifically, the spacer projections 111j of the first substrate 11 and the spacer projections 121j of the second substrate 12 are so provided as to be symmetrical about the center of the top face e. Therefore, the first substrate 11 and the second substrate 12 can be realized by forming the first substrate 11 and the second substrate 12 from a common forming die, and disposing the first substrate 11 and the second substrate 12 in opposite postures.

The projecting piece 111k of the first substrate 11, the projecting piece 121 k of the second substrate 12, and the projecting piece 131k of the third substrate 13 are disposed so as not to overlap with each other. Therefore, in the three-dimensional laminated wiring substrate 1, contact between three external connection terminals 101, 102, 103 formed on the projecting pieces 111k, 121k, 131k is avoided. In addition, each of the external connection terminals 101, 102, 103 is clearly visible, which results in ease of connection work with another component or lead wire.

Conductor patterns 112, 122, 132 different in shape from each other are formed on the first substrate 11, the second substrate 12, and the third substrate 13 in the first embodiment. The conductor pattern 112 is formed from a conductive metal material. The metal materials include copper, nickel, or gold, for example. More specifically, on the insulating films 111, 121, 131 molded so as to constitute a three-dimensional surface with a plating catalyst printed thereon, the three-dimensional wiring substrates 11, 12, 13 have a structure plated by the action of the plating catalyst. The conductor patterns 112, 122, 132 extend on the three-dimensional surfaces of the insulating films 111, 121, 131, respectively, and extends up to the projecting pieces 111k, 121k, 131k. The conductor patterns 112, 122, 132 function as three antenna elements using the external connection terminals 101, 102, 103 as feeding points. These antenna elements have radiation characteristics different from each other according to the shapes of the conductor patterns 112, 122, 132 disposed on the three-dimensional surfaces. For example, the conductor pattern 112 of the first substrate 11 and the conductor pattern 132 of the third substrate 13 have similar frequency characteristics as an antenna, but have different radiation distributions in a space. In addition, the conductor pattern 112 of the first substrate 11 and the conductor pattern 122 of the second substrate 12 have different frequency characteristics.

An electronic device (not shown) provided with the three-dimensional laminated wiring substrate 1 shown in Figure 1 uses the three types of antennas selectively or simultaneously according to the situation. By using the three-dimensional laminated wiring substrate 1, the three types of antennas can be housed in a restricted space such as a corner of the electronic device, for example.

In the first embodiment, the first substrate 11, the second substrate 12, and the third substrate 13 each have a similar three-dimensional surface, and are stacked one on top of another with the three-dimensional surfaces aligned with each other. Therefore, it is easy to position the conductor patterns 112, 122, 132 mutually during assembly. Further, characteristic fluctuations due to interaction or individual differences between products are reduced.

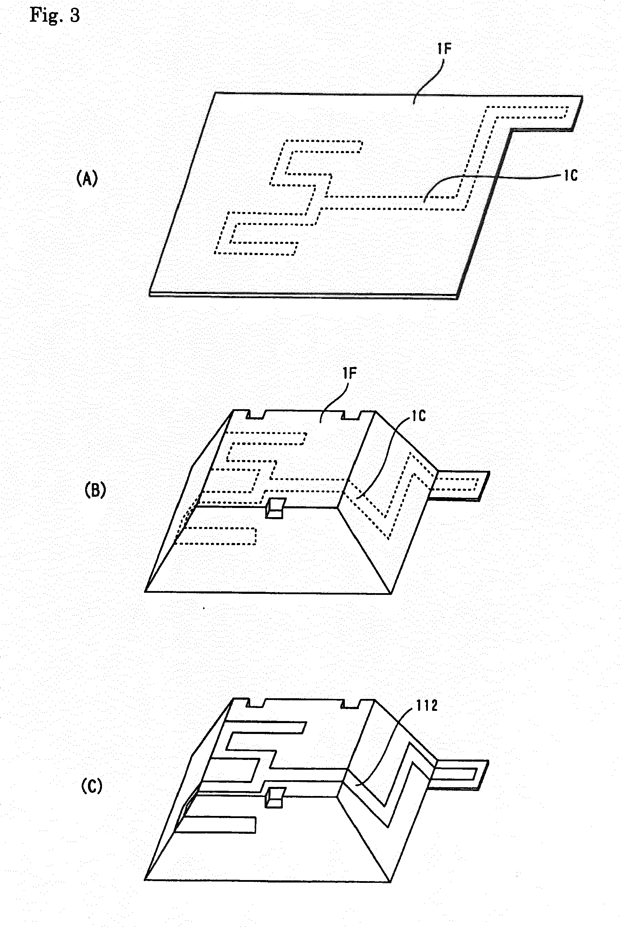

Figure 3 is an illustration of manufacturing steps of the three-dimensional wiring substrate. Parts (A) to (B) of Figure 3 sequentially show manufacturing steps of the first substrate 11 as an example. In this regard, the second and third substrates are also manufactured according to the same steps.

In order to manufacture the first substrate 11, first, as shown in Part (A) of Figure 3, a plating catalyst 1C is printed on a resin insulating film 1F spreading like a flat sheet. The plating catalyst may be a conductive polymer, for example. It should be noted that before printing the plating catalyst 1C, etching or underlayer treatment may be performed.

Next, as shown in Part (B) of Figure 3, the insulating film 1F is heated and molded with a forming die so as to constitute a three-dimensional surface. The forming method may be a vacuum forming method in which the insulating film 1F is sucked to a die by air suction, a pressure forming method in which the insulating film 1 F is pressed to a die by pushing air out, a mechanical embossing method, or the like, for example.

Next, as shown in Part (C) of Figure 3, the formed insulating film is applied with chemical plating. By the action of the plating catalyst 1C, the plating is formed. The conductive pattern 112 made of metal is formed on the portion printed with the plating catalyst 1C. The first substrate 11 is thus completed.

Since plating is performed after the insulating film 1F is formed, the metal conductor pattern 112 is continuously formed without a break at an apex or a ridge line of the three-dimensional surface. Therefore, even if a complicated conductor pattern is formed on a three-dimensional surface, the reliability of connection is high.

Finally, the completed first substrate 11, and the second substrate 12 and the third substrates 13 (see Figure 2) which have been manufactured in the same manner as the first substrate 11 are stacked one on top of another, and fixed to each other with an adhesive or the like. In this manner, the three-dimensional laminated wiring substrate 1 shown in Figure 1 is completed.

Incidentally, it is conceivable that a shape similar to the three-dimensional surface shown in Figure 2 can be formed, for example, by making slits in a flat-sheet-like flexible substrate while assuming the development view of a three-dimensional object, folding the flexible substrate, and further connecting and bonding the edges. In this case, however, the conductor pattern cannot be made continuous across a portion of the three-dimensional surface where the slit is connected and bonded. Therefore, the shape of the conductor pattern is restricted. In addition, formation of a three-dimensional surface is complicated, and therefore difficult to be automated.

Further, in a case where a shape similar to the three-dimensional surface shown in Figure 2 should be manufactured by injection molding or the like, the thickness of a substrate to be formed needs to be thick enough to be formed by injection molding. Therefore, such a substrate cannot be stacked and disposed in such a narrow space as a clearance in an article.

Further, in a case where a multilayered conductor pattern is disposed on a flexible substrate which does not have a three-dimensional surface, formation of a conductor pattern and formation of an insulating layer need to be repeated alternately. Therefore, formation of a multilayered structure is time-consuming. In contrast, the three-dimensional laminated wiring substrate 1 of the first embodiment makes it possible to perform formations of respective layers substantially simultaneously, and combine the three-dimensional surfaces in alignment with each other, thereby performing positioning between the layers. Therefore, a multilayered substrate circuit can be manufactured in a short time with high placement precision.

The three-dimensional laminated wiring substrate 1 thus manufactured makes it possible to densely dispose complicated conductor patterns having high connection reliability on the three-dimensional surface adapted to a limited location in an electronic device or the like.

### <Second Embodiment>

In the three-dimensional laminated wiring substrate 1 of the first embodiment described above, the conductor patterns are formed only on one face, namely, the respective upward convex faces of the first substrate 11, the second substrate 12, and the third substrate 13. Next, a second embodiment of the present invention where conductive patterns are formed on concave faces of the substrates, or both faces thereof will be described.

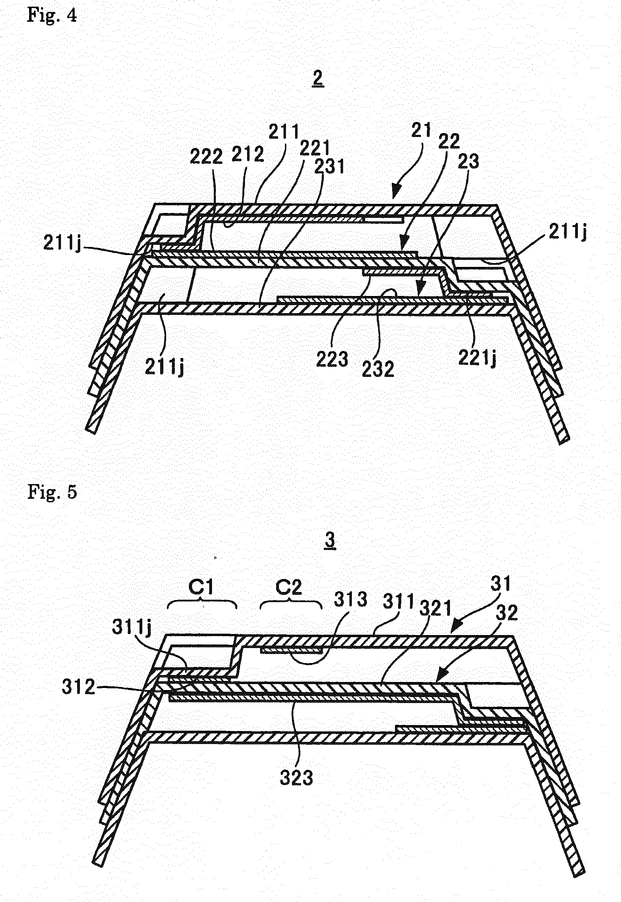

Figure 4 is a sectional view showing the structure of a three-dimensional laminated wiring substrate of the second embodiment.

A three-dimensional laminated wiring substrate 2 shown in Figure 4 is provided with a first substrate 21, a second substrate 22, and a third substrate 23. On the lowermost third substrate 23, a conductor pattern 232 is provided on a convex face of an insulating film 231 in the same manner as the first embodiment. On the other hand, on the uppermost first substrate 21, a conductor pattern 212 is provided on a concave face of an insulating film 211. Further, on the second substrate 22, conductor patterns 222, 223 are provided on both faces of an insulating film 221. It should be noted that, in Figure 4, the thicknesses of the insulating films and the conductor patterns are exaggeratedly shown.

The conductor pattern 212 of the first substrate 21 extends on a surface of a spacer projection 211j of the insulating film 211, and is in contact with the conductor pattern 222 of the second substrate 22. Therefore, the conductor patterns 212, 222 of the first substrate 21 and the second substrate 22 adjacent to each other constitute a circuit.

The conductor pattern 223, which is disposed on the opposite side of the second substrate 22 from the conductor pattern 222, extends on a surface of a spacer projection 221j of the insulating film 221, and is in contact with the conductor pattern 232 of the third substrate 23. Therefore, the conductor patterns 233, 232 of the second substrate 22 and the third substrate 23 adjacent to each other constitute a circuit. It should be noted that the conductor patterns 223, 232 may be joined to each other with soldering, a conductive adhesive, or the like.

Thus, according to the three-dimensional laminated wiring substrate 2, a circuit can be constituted by utilizing two adjacent substrates 21, 22. Further, as clearly shown in Figure 4, since the spacer projections 211j, 221j keep a clearance between the substrates, unnecessary constant between the conductor patterns except the spacer projections 211j 221j is avoided.

### <Third Embodiment>

Next, a third embodiment of the present invention where conductor patterns form a capacitor element will be described.

Figure 5 is a sectional view showing the structure of a three-dimensional laminated wiring substrate of the third embodiment.

In a three-dimensional laminated wiring substrate 3 shown in Figure 5, a horizontal length of a spacer projection 311j formed on an insulating film 311 of a first substrate 31 is longer than that of the spacer projection 211j in the second embodiment (see Figure 4). In addition, a conductor pattern 312 spreading like a flat sheet is provided on a surface of the spacer projection 311j. Further, on the insulating film 311, another conductor pattern 313 spreading like a flat sheet is provided in a position separate from the conductor pattern 312.

No conductor pattern is provided on a convex face of an insulating film 321 of a second substrate 32. A conductor pattern 323 spreading like a flat sheet is provided on a concave face of the second substrate 32 including regions corresponding to the conductor patterns 312, 313 of the first substrate 31.

A first capacitor element C1 is formed by the conductor pattern 323 of the second substrate 32 and the conductor pattern 312 of the first substrate 31. The first capacitor element C1 has an electrostatic capacity according to an overlapped area between the conductor patterns 323, 312 which serve as a pair of parallel plate electrodes, and the thickness and dielectric constant of the insulating film 321. In addition, a second capacitor element C2 is formed by the conductor pattern 323 of the second substrate 32 and the other conductor pattern 313 of the first substrate 31. The second capacitor element C2 has an electrostatic capacity according to an overlapped area between the conductor patterns 323, 313 which serve as a pair of parallel plate electrodes, the thickness and dielectric constant of the insulating film 321, the height of the spacer projection 311j, and the dielectric constant of air. The electrostatic capacity of the second capacitor element C2 can be adjusted according the height of the spacer projection 311j.

### <Fourth Embodiment>

Next, a fourth embodiment of the present invention will be described.

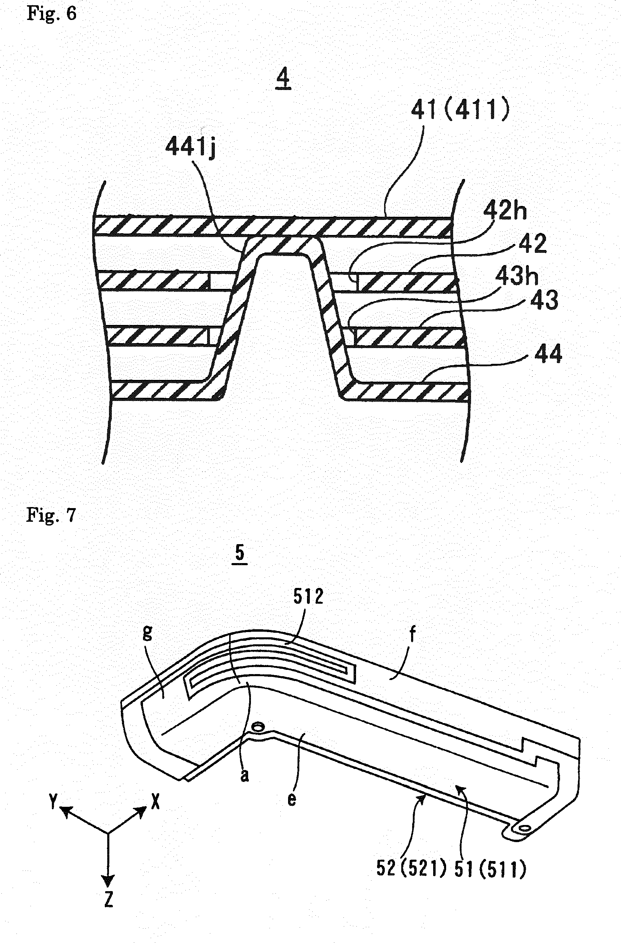

Figure 6 is a sectional view showing a spacer projecting portion of a three-dimensional laminated wiring substrate of the fourth embodiment.

A three-dimensional laminated wiring substrate 4 shown in Figure 6 is a laminate of four three-dimensional wiring substrates which are a first substrate 41, a second substrate 42, a third substrate 43, and a fourth substrate 44. The second substrate 42 and the third substrate 43 are disposed between the first substrate 41 and the fourth substrate 44. The second substrate 42 and the third substrate 43 each correspond to an example of an intermediate three-dimensional wiring substrate defined in the present invention.

Holes 42h, 43h are provided in the second substrate 42 and the third substrate 43, respectively. A spacer projection 441j provided on the fourth substrate 44 abuts on the first substrate 41 through the holes 42h, 43h.

### <Fifth Embodiment>

Next, a fifth embodiment of the present invention will be described.

Figure 7 is a perspective view showing a three-dimensional laminated wiring substrate of the fifth embodiment.

A three-dimensional laminated wiring substrate 5 shown in Figure 7 is a laminate of a first substrate 51 and a second substrate 52 which are two three-dimensional wiring substrates. The first substrate 51 and the second substrate 52 are provided with insulating films 511, 521, respectively, formed so as to constitute a three-dimensional surface. More specifically, the three-dimensional surface of an insulating film 511 has a projecting shape like a trigonal pyramid with faces f, g, e in contact with each other at an apex a, the faces f, g, e facing in mutually independent directions in three dimensions that are a lateral direction X, a longitudinal direction Y, and a height direction Z. The second substrate 52, which is disposed behind (on the back side of) the first substrate, has the same shape. The first substrate 51 and the second substrate 52 are stacked one on top of the other so as to align the three-dimensional surfaces, more specifically, the apexes a, with each other. A conductor pattern 512 functioning as an antenna element extends on the three-dimension surface of the insulating film 511 of the first substrate 51. In addition, an conductor pattern (not shown) functioning as an antenna element and having different shape from the conductor pattern on the first substrate 51 is also formed on the insulating film 521 of the second substrate disposed inside the first substrate 51.

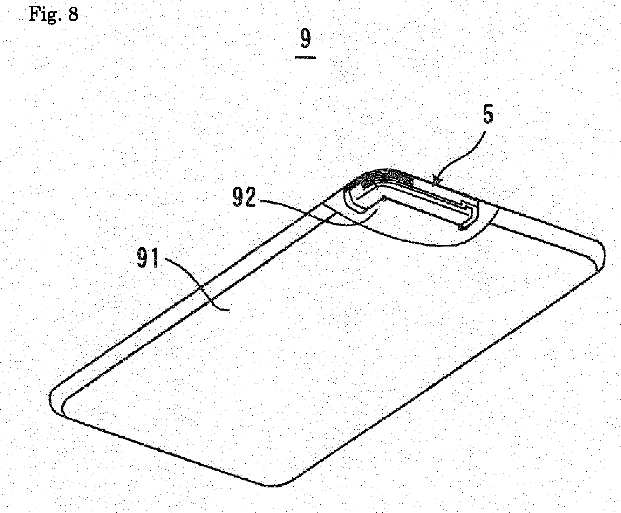

Figure 8 is a perspective view showing an example of application of the three-dimensional laminated wiring substrate in Figure 7.

A mobile communication terminal device 9 is shown as an example of application in Figure 8. An example of the mobile communication terminal device 9 is a smartphone. The mobile communication terminal device 9 has a thin rectangular-parallelepiped-like shape, and the three-dimensional laminated wiring substrate 5 shown in Figure 7 is mounted in a clearance between a case 91 and a built-in component 92 at a corner of the mobile communication terminal device 9. Since the three-dimensional laminate wiring substrate 5 has the structure where the first substrate 51 and the second substrate 52 forming a three-dimensional surface as shown in Figure 7 are stacked one on top of the other, two types of antennas can be built in a limited clearance in the mobile communication terminal device 9.

It should be noted that, in the embodiments described above, a conductor pattern constituting an antenna element is shown as an example of a conductor pattern defined in the present invention. However, this is not intended to limit the present invention, and the conductor pattern may constitute an ordinary closed circuit, for example. In addition, an electronic component may be mounted on the conductor pattern. Therefore, the three-dimensional laminated wiring substrate of the present invention may be applied to a device which does not have a communication function.

Further, in the embodiments described above, structures where two to four substrates are stacked are shown as examples of the three-dimensional laminated wiring substrate defined in the present invention. However, this is not intended to limit the present invention, and the number of three-dimensional wiring substrates to be stacked may be five or more, for example.

Further, in the embodiments described above, the shape of a truncated pyramid and the shape of a pyramid are shown as an example of the shape of a three-dimensional surface defined in the present invention. This, however, is not intended to limit the present invention, and the shape of the three-dimensional surface may be spherical or columnar, for example. In addition, the three-dimensional wiring substrate may be a flat-sheet partially provided with the three-dimensional surface.

Further, in the embodiments described above, the holes 42h, 43h are shown as examples of a hole or a notch defined in the present invention. This, however, is not intended to limit the present invention, and the spacer projection may extend through a notch, for example.

Further, in the embodiments described above, the three-dimensional wiring substrate having the projecting piece 111k is shown as an example of a three-dimensional wiring substrate defined in the present invention. This, however, is not intended to limit the present invention, and the three-dimensional wiring substrate may have no projecting piece, for example.

Further, in the embodiments described above, the substrates provided with conductor patterns having different shapes are shown as examples of a plurality of three-dimensional wiring substrates defined in the present invention. This, however, is not intended to limit the present invention, and the plurality of three-dimensional wiring substrates may be provided with a conductor pattern having the same shape, as in the case of constituting an array antenna, for example.

Further, as an example of a three-dimensional laminated wiring substrate defined in the present invention, elements of the embodiments described above may be used in combination or replaced. For example, on both faces of each substrate of the three-dimensional laminated wiring substrate of the first embodiment or the fifth embodiment, the conductor patterns in the second embodiment may be provided, or the capacitor in the third embodiment may be formed.

### Reference Signs List

- 1, 2, 3, 4, 5: three-dimensional laminated wiring substrate,
- 11, 12, 13, 21, 22, 23, 31, 32, 33, 41, 42, 43, 44, 51, 52: three-dimensional wiring substrate,
- 101, 102, 103: external connection terminal,
- 111j, 121j, 211j, 221j, 311j, 441j: spacer projection,
- 111, 121, 131, 211, 221, 231, 311, 321, 511, 521: insulating film,
- 42h, 43h: hole,
- 111k, 121k, 131k: projecting piece,
- 112, 122, 132, 212, 222, 223, 232, 233, 312, 313, 323, 512: conductor pattern,
- C1, C2: capacitor element.

## Claims

1. A three-dimensional laminated wiring substrate having a plurality of three-dimensional wiring substrates,
wherein each of the plurality of three-dimensional wiring substrates comprises:
an insulating film formed to constitute a three-dimensional surface, and a conductor pattern extending on the three-dimensional surface, and
wherein the plurality of three-dimensional wiring substrates are stacked one on top of another.

2. The three-dimensional laminated wiring substrate according to claim 1, wherein the plurality of three-dimensional wiring substrates have substantially identical three-dimensional surfaces, and are so stacked as to align the substantially identical three-dimensional surfaces with each other.

3. The three-dimensional laminated wiring substrate according to claim 1 or 2, wherein the plurality of three-dimensional wiring substrates are provided with a conductor patterns different in shape from each other, respectively.

4. The three-dimensional laminated wiring substrate according to any one of claims 1 to 3, wherein the three-dimensional wiring substrate is formed with a spacer projection which abuts on another three-dimensional wiring substrate constituting the three-dimensional laminated wiring substrate, thereby keeping a clearance from the another three-dimensional wiring substrate.

5. The three-dimensional laminated wiring substrate according to any one of claims 1 to 4 having more than two three-dimensional wiring substrates, wherein
an intermediate three-dimensional wiring substrate of the more than two three-dimensional wiring substrates that is disposed in an intermediate position is provided with a hole or a notch, and
a spacer projection extends through the hole or notch and abuts on another three-dimensional wiring substrate disposed on the opposite side with respect to the intermediate three-dimensional wiring substrate.

6. The three-dimensional laminated wiring substrate according to claim 4, wherein the conductor pattern of the three-dimensional wiring substrate extends on a surface of the spacer projection, and is in contact with the conductor pattern of the another three-dimensional wiring substrate.

7. The three-dimensional laminated wiring substrate according to claim 4, wherein the conductor patterns of two three-dimensional wiring substrates adjacent to each other of the plurality of three-dimensional wiring substrates form parallel plate electrodes forming a capacitor element.

8. The three-dimensional laminated wiring substrate according to any one of claims 1 to 7, wherein projecting pieces are provided on edges of the plurality of three-dimensional wiring substrates in positions where the projecting pieces do not overlap with each other, and the conductor patterns of the plurality of three-dimensional wiring substrates extend on the projecting pieces of the plurality of three-dimensional wiring substrates.

9. The three-dimensional laminated wiring substrate according to any one of claims 1 to 8, wherein the conductor pattern is a plating formed by the action of a plating catalyst on the insulating film printed with the plating catalyst and formed so as to constitute a three-dimensional surface.
